# EUROPEAN PATENT APPLICATION

(11) **EP 2 787 634 A1**
(43) Date of publication of application: **08.10.2014**
(21) Application number: 14162898.2
(22) Date of filing: 31.03.2014
(51) Int. Cl.: H03C 7/02, H02J 7/02

(54) **Amplitude modulation circuit and non-contact power feeding device**

(30) Priority: 03.04.2013 JP 2013077912
(71) Applicant: Funai Electric Co., Ltd., Daito city Osaka 574-0013 (JP)
(72) Inventor: Wakabayashi, Naoyuki, Osaka, Osaka 574-0013 (JP)
(74) Representative: Osha Liang SARL

(57) **Abstract**

An amplitude modulation circuit includes a resonance circuit powered by an oscillator (1) and comprising a power transmission coil (L1) with a first coil portion (L11), a second coil portion (L12), a modulation coil (L2), and a resonance condenser (C1); and a switch configured to switch between a state where the first coil portion and the second coil portion are connected in series and a state where the first coil portion (L11) and the modulation coil (L2) are connected in series according to a level switching timing of transmission data and a timing when a coil current in the resonance circuit becomes zero. The combined inductance of the first coil portion(L11) and the second coil portion (L12) connected in series and a combined inductance of the first coil portion (L11) and the modulation coil (L2) connected in series are equal.

## Description

The present invention generally relates to an amplitude modulation circuit.

### [Background of Related Art]

Amplitude shift keying (ASK) modulation, which is amplitude modulation modulating a digital signal by changing amplitude of a carrier wave, is known.

For example, a transmitter is able to use ASK modulation, one that turns an N-type FET off or on synchronously with the falling or rising of a synchronization request signal and disconnects or connects a condenser in a resonance circuit and a ground is disclosed in Patent Reference 1.

In accordance with Patent Reference 1, a rising time of a resonance signal (transmission signal) becomes shorter when the condenser is disconnected from the ground because resonance energy is stored in a resonance condenser. Moreover, when resonance starts next, new resonance starts immediately and the rising time of the resonance signal is shortened because resonance energy is already stored in the resonance condenser. High-speed ASK modulation is therefore enabled.

Furthermore, as transmission circuit is able to use ASK modulation, one that turns a switch element off at a timing when energy stored in a condenser of a resonance circuit reaches a maximum is disclosed in Patent Reference 2. A transmission signal is also not output from a coil that is an antenna when the switch element is turned off because there is no energy release from the coil. The switch element turns on when a phase of an input voltage to the resonance circuit matches a phase when the switching element turned off in advance. Resonance can thereby resume immediately, and the coil outputs the transmission signal. High-speed ASK modulation is therefore enabled.

### [Patent References]

[Patent Reference 1] Japanese Unexamined Patent Application Publication No. 2001-45075
[Patent Reference 2] Japanese Unexamined Patent Application Publication No. H4-293320

However, in the technologies disclosed in Patent References 1, 2 described above, transmitted power decreases when transmitting power because only a degree of modulation of 100% is supportable.

### [Summary of the Invention]

One or more embodiments of the present invention provide an amplitude modulation circuit that can support a case where a degree of modulation is less than 100%. The amplitude modulation circuit enables high-speed amplitude modulation.

An amplitude modulation circuit according to one or more embodiments of the present invention may comprise a resonance circuit powered by an oscillator and comprising a power transmission coil with a first coil portion, a second coil portion, a modulation coil, and a resonance condenser; and a switch configured to switch between a state where the first coil portion and the second coil portion are connected in series and a state where the first coil portion and the modulation coil are connected in series according to a level switching timing of transmission data and a timing when a coil current in the resonance circuit becomes zero, wherein a combined inductance of the first coil portion and the second coil portion connected in series and a combined inductance of the first coil portion and the modulation coil connected in series are equal. The combined inductances may be equivalent by design, but a case where a slight error occurs in the actual machine is within the scope of the present configuration.

According to one or more embodiments, a state where the magnetic field is radiated from the first coil portion and the second coil portion and a state where the magnetic field is radiated from the first coil portion alone may be switched to perform amplitude modulation. For example, transmitted power can be suppressed from decreasing because a degree of modulation can be set freely by a split ratio of the first coil portion and the second coil portion and an amplitude can be made to a value other than zero at a location where an amplitude of a radiation magnetic field decreases.

For example, energy loss may be suppressed because the switch is configured to switch at the timing when the coil current becomes zero, that is, when energy stored in the resonance condenser reaches a maximum. Moreover, a resonance frequency does not change because the combined inductance does not change before and after switching. A response time of amplitude change of the radiation magnetic field during modulation can therefore be made as short as possible, enabling high-speed amplitude modulation.

Furthermore, in one or more embodiments, the switch is configured to switch at a timing when the coil current reaches zero. For example, energy loss can be eliminated, and the response time of amplitude change of the radiation magnetic field during modulation can be made as short as possible.

Furthermore, in one or more embodiments, a frequency of the oscillator may be an integer multiple of an amplitude modulation frequency and the level switching timing of the transmission data and the timing when the coil current becomes zero may coincide. For example, modulation can be performed in correspondence with the level switching timing of the transmission data.

Furthermore, in one or more embodiments, the level switching timing of the transmission data may be shifted from the timing when the coil current becomes zero, and the switch may switch at the timing when the coil current becomes zero after the level switching timing of the transmission data.

Furthermore, in one or more embodiments, the resonance condenser may comprise in a series a coil part formed of the power transmission coil and the modulation coil. For example, an oscillator with low impedance can be used, widening a scope of use.

Furthermore, in one or more embodiments, the resonance condenser may comprisein parallel the coil part formed of the power transmission coil and the modulation coil. For example, an oscillator with high impedance can be used.

Furthermore, in one or more embodiments, the modulation coil may be disposed so a center axis thereof is orthogonal to a center axis of the first coil portion. For example, the modulation coil can be made to not be involved in magnetic field radiation of the first coil portion at a low cost.

Furthermore, in one or more embodiments, the modulation coil may comprise a toroidal core member wrapped with a coil. For example, magnetic field radiation to outside from the modulation coil can be suppressed and be made to not be involved in magnetic field radiation of the first coil portion, also enabling space saving.

Furthermore, in one or more embodiments, a transmission data generator configured to generate the transmission data based on source data and a subcarrier may be further provided. For example, interference with another transmission signal can be suppressed by a frequency of the subcarrier.

Furthermore, a non-contact power feeding device according to one or more embodiments of the present invention may comprise the amplitude modulation circuit according to any of the configurations described above and an oscillator configured to feed power to the resonance circuit provided in the amplitude modulation circuit.

According to one or more embodiments of the present invention, reducing the transmitted power during modulation is suppressed and high-speed amplitude modulation is enabled.

### [Brief Description of Drawings]

FIG. 1 is a configuration diagram of a non-contact power feeding device according to one or more embodiments of the present invention.
FIG. 2 is a diagram illustrating an example of an oscillator according to one or more embodiments of the present invention.
FIG. 3 is a timing chart illustrating an example of a detection timing of a condenser voltage, a coil current, and a coil current zero according to one or more embodiments of the present invention.
FIG. 4 is a timing chart illustrating an example of the detection timing of the coil current and a transmission data, each coil current, and a radiation magnetic field according to one or more embodiments of the present invention.
FIG. 5 is a diagram illustrating an example where the non-contact power feeding device, according to one or more embodiments of the present invention, is applied to charging an electric vehicle.
FIG. 6 is a configuration diagram of a non-contact power feeding device according to one or more embodiments of the present invention.
FIG. 7 is a diagram illustrating a transmission data generator according to one or more embodiments of the present invention.
FIG. 8 is a diagram illustrating a generation method of transmission data according to one or more embodiments of the present invention.
FIG. 9 is a diagram illustrating an example where a non-contact power feeding device, according to one or more embodiments of the present invention, is applied to charging an electric toothbrush.

### [Detailed Description of Embodiments]

### (First Example)

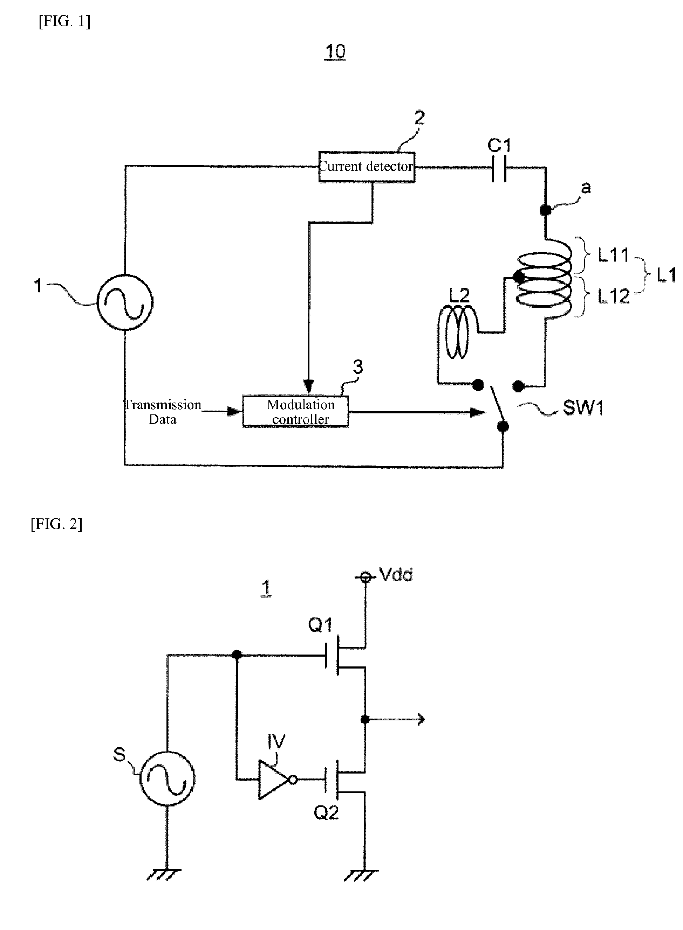

One or more embodiments of the present invention will be described below with reference to the drawings. FIG. 1 illustrates a configuration of a non-contact power feeding device according to one or more embodiments of the present invention. A non-contact power feeding device 10 illustrated in FIG. 1 comprises an oscillator 1, a current detector 2, a modulation controller 3, a resonance condenser C1, a power transmission coil L1, a modulation coil L2, and a change-over switch SW1. An ASK modulation circuit is configured from the current detector 2, the modulation controller 3, the resonance condenser C1, the power transmission coil L1, the modulation coil L2, and the change-over switch SW1.

The power transmission coil L1 is split into a first coil portion L11 and a second coil portion L12, and the resonance condenser C1. The first coil portion L11, and the second coil portion L12 are connected in series. Moreover, a connection point of the first coil portion L11 and the second coil portion L12 is connected to one end of the modulation coil L2, and the resonance condenser C1. The first coil portion L11, and the modulation coil L2 are also connected in series. A serial resonance circuit is, therefore, formed from the resonance condenser C1, the power transmission coil L1, and the modulation coil L2.

An oscillation frequency of the oscillator 1 configured to feed power to the serial resonance circuit is set to a resonance frequency of the serial resonance circuit. The oscillator 1 can use one with low impedance, and an example thereof is illustrated in FIG. 2. The oscillator 1 shown as an example in FIG. 2 comprises an oscillation signal source S, switch elements Q1 and Q2, and an inverter IV. The oscillation signal source S may be connected directly to a control terminal of the switch element Q1, and the oscillation signal source S is connected to a control terminal of the switch element Q2 via the inverter IV. The switch elements Q1 and Q2 are connected in series between a power source Vdd and a ground, and an output spawns from a connection point between the switch elements Q1 and Q2. The power source Vdd can be set to, for example, 5 V, 100 V, or the like, according to a use of the non-contact power feeding device.

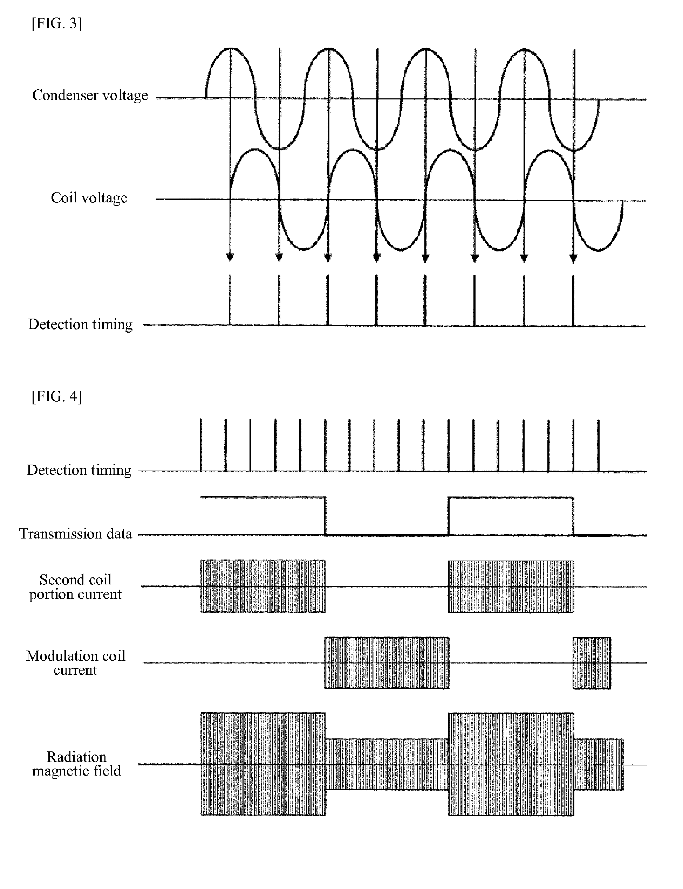

The change-over switch SW1 is a switch configured to perform connection switching between one end side of the second coil portion L12 and one end side of the modulation coil L2. When the change-over switch SW1 is switched to one end side of the second coil portion L12, the first coil portion L11 and the second coil portion L12 become connected in series; power from the oscillator 1 is fed to the resonance condenser C1, the first coil portion L11, and the second coil portion L12; and energy is alternately exchanged between the resonance condenser C1 and the resonance coil comprising the first coil portion L11 and the second coil portion L12 at a period of the resonance frequency. At this time, as illustrated in FIG. 3, a coil current becomes zero when a voltage of the resonance condenser C1 peaks.

Meanwhile, when the change-over switch SW1 is switched to one end side of the modulation coil L2, the first coil portion L11 and the modulation coil L2 become connected in series; power from the oscillator 1 is fed to the resonance condenser C1, the first coil portion L11, and the modulation coil L2; and energy is alternately exchanged between the resonance condenser C1 and the resonance coil comprising the first coil portion L11 and the modulation coil L2, at the period of the resonance frequency. As illustrated in FIG. 3, the coil current becomes zero when the voltage of the resonance condenser C1 peaks.

The change-over switch SW1 may switche to the resonance coil comprising the first coil portion L11 and the second coil portion L12 and to the resonance coil configured from the first coil portion L11 and the modulation coil L2, but an inductance (combined inductance) of both resonance coils is set to be the same. The resonance frequency can thereby be made to not change even when switching from one resonance coil to another.

The modulation controller 3 is configured to detect a timing when the coil current detected by the current detector 2 becomes zero. FIG. 3 illustrates a timing when the coil current is detected as becoming zero. This timing is the same timing as when energy stored in the resonance condenser C1 reaches a maximum, that is, a timing when a condenser voltage peaks. The modulation controller 3 may detect a timing when a voltage of the resonance condenser C1 and a connection point a of the first coil portion peaks, without providing the current detector 2.

Furthermore, the modulation controller 3 may switch the change-over switch SW1 according to a timing when a label of transmission data, which is input digital data, switches and a timing when the coil current becomes zero.

Specifically, a change-over switch SW is switched from one end side of the second coil portion L12 to one end side of the modulation coil L2 according to a timing when the transmission data switches from a HIGH level to a LOW level and the timing when the coil current becomes zero. An example illustrated in FIG. 4 switches at the timing when the coil current becomes zero because a label switching timing of the transmission data and a detection timing of when the coil current becomes zero coincide. The coil current passing through the first coil portion L11 and the second coil portion L12 before switching thereby switches to the coil current passing through the first coil portion L11 and the modulation coil L2. That is, as illustrated in FIG. 4, the current stops passing through the second coil portion L12, and, instead, passes through the modulation coil L2.

Energy is not lost because switching occurs when the coil current becomes zero, that is, when the energy stored in the resonance condenser C1 reaches its maximum. The coil current then passes through at the same amplitude immediately after switching as immediately before switching because the resonance frequency does not change before and after switching.

Here, the modulation coil L2 is, for example, disposed so a center axis of the modulation coil is orthogonal to a center axis of the first coil portion L11 (power transmission coil L1), and the modulation coil L2 may not involved in magnetic field radiation of the first coil portion L11. Therefore, a magnetic field radiated from the first coil portion L11 and the second coil portion L12 in an axis direction before switching switches to a magnetic field radiated only from the first coil portion L11 in the axis direction. The radiated magnetic field is transmitted as a transmission signal to a power receiving device (not illustrated) having a power reception coil on an axis of the power transmission coil L1. Power transmission and data communication are thereby performed between the non-contact power feeding device 10 and the power receiving device.

As illustrated in FIG. 4, an amplitude of a radiation magnetic field decreases compared to before switching because the magnetic field is radiated only from the first coil portion L11 after switching.

Furthermore, the change-over switch SW is switched from one end side of the modulation coil L2 to one end side of the second coil portion L12 according to the timing when the transmission data switches from the LOW level to the HIGH level and the timing when the coil current becomes zero. The example illustrated in FIG. 4 may switch at the timing when the coil current becomes zero because the label switching timing of the transmission data and the detection timing of when the coil current becomes zero coincide. The coil current passing through the first coil portion L11 and modulation coil L2 before switching thereby switches to the coil current passing through the first coil portion L11 and the second coil portion L12. That is, as illustrated in FIG. 4, the current may stop passing through the modulation coil L2, and, instead, the current starts to pass through the second coil portion L12.

In the same manner as described above, the coil current passes through at the same amplitude immediately after switching as immediately before switching because energy is not lost and the resonance frequency does not change before and after switching. Then, as illustrated in FIG. 4, the amplitude of the radiation magnetic field increases compared to before switching because the magnetic field radiated only from the first coil portion L11 switches to a magnetic field radiated from the second coil portion L12 in addition to the first coil portion L11.

A degree of modulation of this type of ASK modulation is represented by (Magnetic field intensity of first coil portion L11) / (Magnetic intensity of first coil portion L11 and second coil portion L12), and the degree of modulation can be set freely by setting a split ratio (near a turn ratio) of the first coil portion L11 and the second coil portion L12 in the power transmission coil L1. Therefore, the amplitude can be set to a value other than zero at a location where the amplitude of the radiation magnetic field is small during modulation, and the transmitted power can be suppressed from decreasing when transmitting power.

Furthermore, a response time of amplitude change of the radiation magnetic field can be made as short as possible because the coil current (resonance current) passes through at the same amplitude immediately after switching as immediately before switching. High-speed ASK modulation is therefore enabled.

The modulation coil L2 that is not involved in magnetic field radiation of the first coil portion L11 may comprise a toroidal core member wrapped with a coil. Magnetic flux radiation from the modulation coil L2 to outside can thereby be suppressed, which is also effective for saving space.

Furthermore, the timing when the coil current becomes zero and a level switching timing of the transmission data can be synchronized (coincided) if the frequency of the oscillator 1 is made to be an integer multiple of an ASK modulation frequency. Specifically, the timing when the coil current becomes zero can be shifted from the level switching timing of the transmission data. In this case, the change-over switch SW1 may be switched at the timing when the coil current becomes zero immediately after the level switching timing of the transmission data.

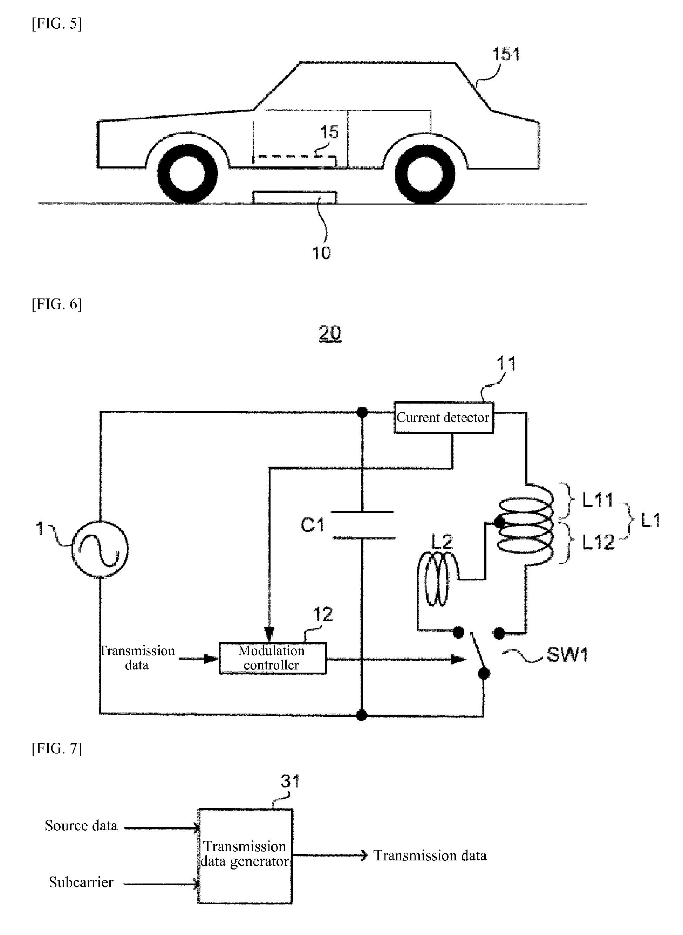

Furthermore, FIG. 5 illustrates a schematic system example where the non-contact power feeding device 10, according to one or more embodiments, is applied in charging an electric vehicle. As illustrated in FIG. 5, the non-contact power feeding device 10 is disposed on a ground side so as to oppose a power receiving device 15 provided in a parked electric vehicle 151 at a facility such as a charging stand, a parking lot, or the like. Power is thereby transmitted from the non-contact power feeding device 10 to the power receiving device 15, and power is charged to a battery of the electric vehicle 151. Moreover, data transmission from the non-contact power feeding device 10 to the power receiving device 15 can be performed.

The non-contact power feeding device 10 according to one or more embodiments of the present embodiment is applicable not only to charging a vehicle but also to charging, for example, an electric toothbrush, a smart phone, or the like.

### (Second Example)

Next, a configuration of a non-contact power feeding device according to one or more embodiments of the present invention is illustrated in FIG. 6. As a point of difference from the first example, a power transmission coil L1 configured from a first coil portion L11 and a second coil portion L12 or a coil part configured from the first coil portion L11 and a modulation coil L2 is connected in parallel with a resonance condenser C1 in a non-contact power feeding device 20 illustrated in FIG. 6. A parallel resonance circuit is, therefore, formed from the resonance condenser C1, the power transmission coil L1, and the modulation coil L2.

A modulation controller 12 is configured to switch a change-over switch SW1 according to a timing when a label of transmission data, which is input digital data, switches and a timing when a coil current detected by a current detector 11 becomes zero. A timing when both end voltages of the resonance condenser C1 in FIG. 6 peak may be detected and the change-over switch SW1 switched according to this timing.

Further, a degree of modulation can be set freely by a split ratio of the first coil portion L11 and the second coil portion L12. Particularly, an amplitude can be made to a value other than zero at a location where an amplitude of a radiation magnetic field decreases, and transmitted power can be suppressed from decreasing. Moreover, a coil current (resonance current) passes through immediately after switching at an amplitude of immediately before switching because energy stored in the resonance condenser C1 reaches a maximum and there is no energy loss when switching the change-over switch SW1. A response time of amplitude change of the radiation magnetic field during modulation can therefore be made as short as possible, enabling high-speed ASK modulation.

Effects described above are the same as those of the first example, but the second example works well in conjunction with an oscillator of high impedance.

### (Third Example)

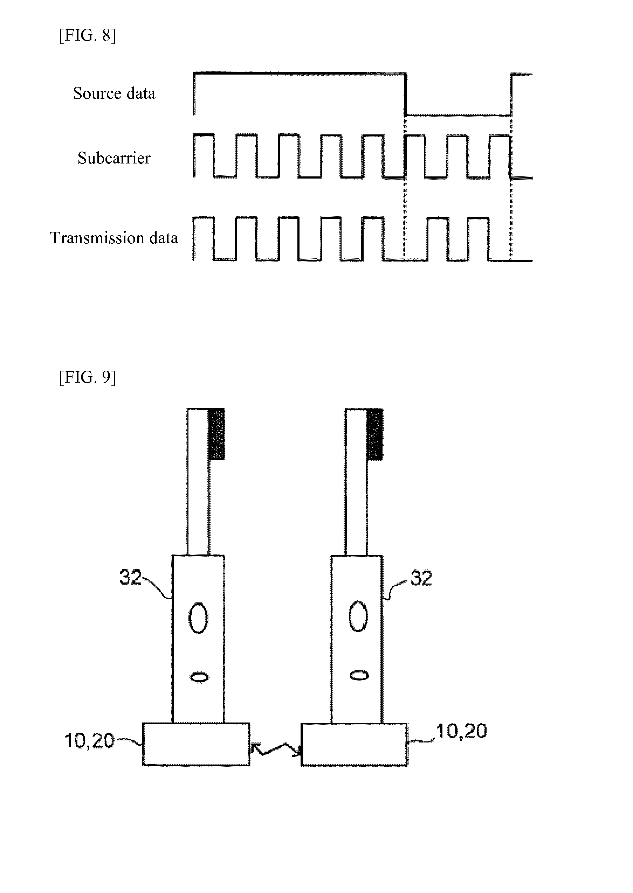

Next, a third example of the present invention will be described. A feature of one or more embodiments of the present invention is a generation method of the transmission data in the first and second examples described above. FIG. 7 illustrates a configuration of generating transmission data according to one or more embodiments of the present embodiment, and FIG. 8 illustrates a waveform example in generating the transmission data. As illustrated in FIG. 7, a transmission data generator 31 generates the transmission data based on input source data and a subcarrier. The transmission data generator 31 may be provided in a preceding step to the modulation controller 3 (first embodiment) or the modulation controller 12 (second embodiment) described above.

As illustrated in FIG. 8, the subcarrier becomes the transmission data as is at a location of a HIGH level in the source data, and the subcarrier is inverted at a location of a LOW level in the source data to generate the transmission data.

For example, FIG. 9 illustrates a schematic configuration example of the non-contact power feeding device 10 or 20 that applies the transmission data generator 31 to charging an electric toothbrush. As illustrated in FIG. 9, data communication and power transmission can be performed by placing an electric toothbrush 32 on the non-contact power feeding device 10 or 20 and radiating an ASK modulated magnetic field from the non-contact power feeding device 10 or 20 to the electric toothbrush 32.

As illustrated in FIG. 9, it is also possible to dispose a plurality of adjacent non-contact power feeding devices 10 or 20 on which the electric toothbrush 32 is placed. In this case, a signal transmitted from a neighboring non-contact power feeding device is sometimes transmitted to the electric toothbrush 32 placed on an own non-contact power feeding device. A frequency of the subcarrier can suppress interference with a transmission signal from an adjacent non-contact power feeding device even in a case such as this because the subcarrier is used in communicating from the non-contact power feeding device to the electric toothbrush 32.

The present invention is not limited to an electric toothbrush but is also applicable to, for example, a charging stand or the like for an electric vehicle wherein adjacent non-contact power feeding devices are lined up.

Although the disclosure has been described with respect to only a limited number of embodiments, those skilled in the art, having benefit of this disclosure, will appreciate that other embodiments can be devised.

### [Explanation of Reference Numerals]

1 Oscillator
2 Current detector
3 Modulation controller
C1 Resonance condenser
L1 Power transmission coil
L11 First coil portion
L12 Second coil portion
L2 Modulation coil
SW1 Change-over switch
10, 20 Non-contact power feeding device
11 Current detector
12 Modulation controller
15 Power receiving device
151 Electric vehicle
31 Transmission data generator
32 Electric toothbrush

## Claims

1. An amplitude modulation circuit, comprising:
a resonance circuit powered by an oscillator (1) and comprising a power transmission coil (L1) with a first coil portion (L11), a second coil portion (L12), a modulation coil (L2), and a resonance condenser (C1); and
a switch (SW1) configured to switch between a state where the first coil portion (L11) and the second coil portion (L12) are connected in series and a state where the first coil portion (L11) and the modulation coil (L2) are connected in series according to a level switching timing of transmission data and a timing when a coil current in the resonance circuit becomes zero,
wherein a combined inductance of the first coil portion (L11) and the second coil portion (L12) connected in series and a combined inductance of the first coil portion (L11) and the modulation coil (L2) connected in series are equal.

2. The amplitude modulation circuit according to claim 1, wherein:
the switch (SW1) is configured to switch when the coil current reaches zero.

3. The amplitude modulation circuit according to claim 2, wherein:
a frequency of the oscillator (1) is an integer multiple of an amplitude modulation frequency and the level switching timing of the transmission data and the timing when the coil current becomes zero coincide.

4. The amplitude modulation circuit according to claim 2, wherein:
the level switching timing of the transmission data is shifted from the timing when the coil current becomes zero, and
the switch is configured to switch at the timing when the coil current becomes zero after the level switching timing of the transmission data.

5. The amplitude modulation circuit according to any of claims 1 to 4, wherein:
the resonance condenser (C1) comprises in series a coil part comprising the power transmission coil (L1) and the modulation coil (L2).

6. The amplitude modulation circuit according to any of claims 1 to 4, wherein:
the resonance condenser (C1) comprises in parallel the coil part comprising the power transmission coil (L1) and the modulation coil (L2).

7. The amplitude modulation circuit according to any of claims 1 to 6, wherein:
the modulation coil (L2) is disposed so a center axis of the modulation coil (L2) is orthogonal to a center axis of the first coil portion (L11).

8. The amplitude modulation circuit according to any of claims 1 to 6, wherein:
the modulation coil (L2) comprises a toroïdal core member wrapped with a coil.

9. The amplitude modulation circuit according to any of claims 1 to 8 further comprising:
a transmission data generator (31) configured to generate transmission data based on source data and a subcarrier.

10. A non-contact power feeding device (10, 20), comprising:
an amplitude modulation circuit according to any of claims 1 to 9; and
an oscillator (1) configured to feed power to the resonance circuit in the amplitude modulation circuit.
